(19) Europäisches Patentamt
European Patent Office
Office européen des brevets

(11) Publication number: **0 354 769 B1**


(12) # EUROPEAN PATENT SPECIFICATION


(45) Date of publication of patent specification: **09.11.94**

(51) Int. Cl.5: **C04B 35/00**, H05B 33/28, C23C 14/34, H01B 1/08, C23C 14/08

(21) Application number: **89308069.7**

(22) Date of filing: **09.08.89**

The file contains technical information submitted after the application was filed and not included in this specification


(54) **Zinc oxide sintered body and preparation process thereof.**


(30) Priority: **09.08.88 JP 197157/88**

(43) Date of publication of application:
**14.02.90 Bulletin 90/07**

(45) Publication of the grant of the patent:
**09.11.94 Bulletin 94/45**

(84) Designated Contracting States:
**AT CH DE FR GB LI NL**



(56) References cited:
**DE-A- 3 639 508**

**DATABASE WPIL Derwent Publications Ltd.,LONDON, GB; DATABASE WPIL, accession no. 88-240311, week 8834; & JP-63175304, 19 July 1988**

**BRITISH CERAMIC vol. 86, no. 6, November-December 1987, pages 190-193, Shelton, Stoke-on-Trent, GB; T. ASOKAN et al.:"Influence of Additive Oxides on the Electrical Characteristics of ZnO-Based Composites"**



(73) Proprietor: **Tosoh Corporation**
**4560, Kaisei-cho**
**Shinnanyo-shi, Yamaguchi-ken (JP)**

(72) Inventor: **Ogawa, Nobuhiro**
**2575, Oaza-Tonda**
**Shinnanyo-shi Yamaguchi (JP)**
Inventor: **Harada, Ichiro**
**5-7, Nishimasu-cho**
**Shinnanyo-shi Yamaguchi (JP)**
Inventor: **Mori, Takashi**
**15-4, Doi 2-chome**
**Shinnanyo-shi Yamaguchi (JP)**
Inventor: **Baba, Hironori**
**3-71, Jonan-cho 3-chome**
**Yamagata-shi Yamagata (JP)**

(74) Representative: **Sheard, Andrew Gregory et al**
**Kilburn & Strode**
**30, John Street**
**London WC1N 2DD (GB)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



EP 0 354 769 B1

**JOURNAL OF APPLIED PHYSICS vol. 55, no. 4, 15 February1984, pages 1029-1034, New York, US; H. NANTO et al.: "Electrical and optical properties of zinc oxide thin films prepared by rf magnetron sputtering for transparent electrode applications"**

## Description

The present invention relates to an electroconductive metal oxide sintered body, a process for its preparation and uses thereof. More particularly, the present invention relates to a zinc oxide sintered body for use in making a transparent electroconductive film, for example, by the sputtering method, a process for its preparation and uses thereof.

The demand for a transport electroconductive metal oxide film as a transparent electrode of a solar cell or display device, or as an electroconductive coating for obtaining an antistatic effect, has recently increased.

Transparent electroconductive films of electroconductive metal oxides are mainly made by sputtering of metal oxides. More specifically, transparent electroconductive films have heretofore been prepared by sputtering a sintered body of indium oxide doped with tin (ITO) or a sintered body of tin oxide doped with antimony.

In the case of ITO, an electroconductive film having high transparency and low resistance can be formed, but since indium is expensive, ITO is disadvantageous from the economical viewpoint. Moreover, since ITO is chemically unstable, the application range is narrow.

Antimony-doped tin oxide is cheap and chemically stable, but this doped tin oxide has a high resistance and is not fully satisfactory as the material for an electroconductive film.

It was recently reported that a transparent electroconductive film having a resistance as low as that of ITO and an excellent transparency can be prepared by sputtering zinc oxide doped with aluminium as a dopant [J. Appl. Phys., 55(4), 15 February 1984, page 1029].

DE-A-3639508 discloses a process in which a zinc oxide aluminium oxide mixture is sintered at 900 to 1000 °C and thereafter heat treated at 1300 °C. It discloses a film made by sputtering and does not disclose the properties of the body which was subjected to sputtering in order to make the film.

Since zinc oxide is cheap and chemically stable and has an excellent transparency and electroconductivity, zinc oxide is an excellent transparent electroconductive material that can be used instead of ITO.

The conventional dopant-incorporated zinc oxide sintered body as a sputtering target is prepared through a heat treatment conducted at a temperature not higher than 1,300 °C in air, and the hue of this sintered body is white and the resistance is very high; namely the specific resistance is several kΩ.cm or higher. Accordingly, the sputtering method to which this conventional target can be applied is limited to the high-frequency sputtering method for insulators, and it is difficult to apply this conventional target to the industrial direct current sputtering method which can be used for conductors.

If such a high-resistance sintered body is used in the direct current sputtering method, an applicable electric power is extremely small and the discharge is very unstable, and continuous operation is difficult.

A primary object of the present invention is to provide a zinc oxide sintered body which is characterized as possessing a high density and a very low specific resistance, and is useful as the sputtering target for formation of a transparent electroconductive film.

In one aspect of the present invention, there is provided a zinc oxide sintered body containing from 0.1 to 20% by weight, based on the amount of zinc, of an oxide of an element having a valency of at least three positive valences, which has a sintered density of at least 5 g/cm$^3$ and a specific resistance lower than 1Ω.cm.

Preferably the zinc oxide sintered body is doped with a different element as a dopant, wherein the total amount of the spinel structure contained in the sintered body does not exceed the amount of spinel (expressed by the formula $ZnX_2O_4$ in which X represents the element added as a dopant) which would be formed if all the dopant element was present as a spinel structure. This zinc oxide sintered body may be prepared by sintering zinc oxide containing from 0.1 to 20% by weight, based on the amount of zinc, of an oxide of an element having a valency of at least three positive valences at a temperature of at least 1400 °C in air, or at a temperature of at least 1300 °C in an inert atmosphere or in vacuo. This zinc oxide containing the element is preferably in the form of a highly dispersible powder having a primary particle diameter not larger than 1μm (micrometre) and a specific surface area of at least 2 m$^2$/g.

Preferably a spinel structure oxide represented by the formula $ZnX_2O_4$, wherein X represents the said element, is mixed with zinc oxide, and the mixture is sintered. The spinel structure oxide of the formula $ZnX_2O_4$ may be prepared by a heat treatment at a temperature of 500 to 1,000 °C. The sintering is preferably carried out at a temperature of lower than 1700 °C.

The invention also extends to a sputtering target comprising a sintered body in accordance with the present invention.

By way of example, in the accompany drawings:-

Figure 1 is a scanning electron microscope photograph (2,000 magnifications) showing the structure of crystal particles of a sintered body obtained by carrying out sintering at 1,400 ° C in air according to the present invention;

Figure 2 is a similar photograph illustrating a sintered body obtained by carrying out sintering at 1,100 ° C in air;

Figure 3 is an X-ray diffraction chart of a sintered body according to the present invention obtained in Example 4; and Figure 4 is an X-ray diffraction chart of the sintered body obtained in Example 6.

The element (electroconductive active element) having a valency of at least three positive valences, which is used as the dopant for imparting the electroconductivity in the present invention, is an element present in the state where the valency is trivalent or higher. As examples of the element of this type, there can be mentioned Sc and Y of the group IIIa of the Periodic Table, B, Al, Ga, In and Tl of the group IIIb of the Periodic Table Ti, Zr, Hf and Th of the group IVA of the Periodic Table, C, Si, Ge, Sn and Pb of the group IVb of the Periodical Table, V, Nb, Ta and Pa of the group Va of the Periodic Table, As, Sb and Bi of the group Vb of the Periodic Table, Cr, Mo, W and U of the group VIa of the Periodic Table, Se, Te and Po of the group VIb of the Periodic Table, Mn, Tc and Re of the group VIIa of the Periodic Table, Fe, Co, Ni, Ru, Rh, Pd, Os, Ir and Pt of the group VIII of the periodic Table, and elements of the lanthanide and actinide series. The amount of the electroactive element used is 0.1 to 20% by atomic weight, preferably 0.5 to 5%, based on zinc. If a starting material having this atomic composition is used, a zinc oxide sintered body having a low resistance can be obtained. Preferred elements include those from the groups IIIb (e.g. Al, In), IVb (e.g. Sn, Si, Ge) and IVa (e.g. Zr, Ti).

Starting materials satisfying the above-mentioned requirement of the atomic composition can be used in the present invention, regardless of the preparation method.

For example, there can be mentioned a method in which zinc oxide is merely mixed with an oxide of an electroconductive active element, a method in which a mixture of a zinc compound and a compound of an electroconductive active element, for example, a hydroxide, organic salt or inorganic salt thereof, is thermally decomposed, and a method in which a mixed solution containing zinc and an electroconductive active element at the above-mentioned ratio is subjected to coprecipitation according to customary procedures and the coprecipitate is thermally decomposed to form the intended oxide. Oxide powders prepared according to these methods can be used in the present invention without any particular limitations of the physical properties, if the above-mentioned requirement of the atomic composition is satisfied. Nevertheless, a highly dispersible powder having a primary particle diameter not larger than 1 um and a specific surface area of at least 2 $m^2$ /g, as determined from the particle diameter distribution, is preferred. If this highly dispersible fine powder is used, both the sintered density of the obtained sintered body and electro conductivity can be improved.

Further research was carried out and as a result, it was found that, in the conventional method, the different element (dopant) added for reducing the electrical resistance of the sintered body forms a spinel structure compound (expressed by the formula $ZnX_2O_4$ in which X stands for the different element) during the sintering and other spinel structures, which do not contain the element X, are inevitably formed in the vicinity of the so-formed spinel structure compound of the formula $ZnX_2O_4$ with the result that the total amount of the spinel structures formed in the sintered body is larger than the amount of the spinel structure of the formula $ZnX_2O_4$ as obtained if the entire amount of the different element added as a dopant takes the spinel structure, and that this excessively formed spinel structure (not having the element X) greatly lowers the electroconductivity of the sintered body.

It was found that, if as the means of addition of the different element, a method is adopted in which a spinel compound ($ZnX_20_4$) of the different element (X) and zinc is mixed with zinc oxide and the mixture is sintered at a temperature of at least 1400 ° C in air or at a temperature of at least 1300 ° C in an inert atmosphere or in vacuo, the added element (X) acts effectively as the dopant and the proportion of the spinel structure in the sintered body is markedly reduced. It also was found that the product obtained according to this method has an excellent low-resistance sintered body having a specific resistance lower than 10 mΩ.cm and a sinter density of at least 5 g/$cm^3$, and this sintered body may have an excellent performance as the sputtering target.

The above-mentioned elements having a valency of at least three positive valences can be used as the dopant element.

The amount of the dopant element used is suitably 0.1 to 20 by atomic weight, preferably 0.5 to 4%, based on zinc. If the starting material having this atomic composition is used, a low-resistance zinc oxide sintered body may be obtained. This atomic ratio corresponds to the spinel structure oxide molar ration of 0.05 to 10%, preferably 0.25 to 2%.

The element to be doped is formed into a spinel compound with zinc, and the spinel compound is then mixed with zinc oxide. The method for preparing this spinel structure compound is not particularly critical, and any method can be adopted. For example, there can be considered a method in which oxides of these elements are mixed with zinc oxide and the mixture is heat-treated, and a method of forming a more uniform spinel compound, in which compounds of the dopant element and zinc, for example, hydroxides, are coprecipitated and the coprecipitate is heated and dehydrated.

The formation of the spinel compound begins at about 500 ° C. Preferably the spinel compound formed at a temperature of about 500 to 1,000 ° C is used. In the spinel compound formed at a higher temperature, thermal aggregation occurs, and it is difficult to mix this spinel structure uniformly with zinc oxide. At a lower temperature, no spinel structure is formed, and it is difficult to obtain the intended effect of the present invention.

The sintered body of the present invention is prepared by preliminarily molding the oxide powder obtained according to the above-mentioned method into an intended shape by a customary means, for example, by an addition of a binder, and sintering the molded body at a high temperature. The sintering is carried out at a temperature of at least 1,400 ° C, in air or at a temperature of at least 1300 ° C in an inert atmosphere or in vacuo. Although the melting point of zinc oxide is about 1,800 ° C, the melting point is lowered by the addition of the electroconductive active element and the electroconductive active element-incorporated zinc oxide becomes molten at a temperature lower than the inherent melting point of zinc oxide. Accordingly, the sintering temperature is preferably lower than 1,700 ° C, more preferably lower than 1,600 ° C.

If the sintering temperature is at least 1,400 ° C, the grain boundary of sintered particles begins to melt and the sintered body is colored blue or green. But, if the grain boundary of the sintered particles is completely molten, although the specific resistance is reduced, often pores cut from the exterior are left in the interior of the sintered body. If sputtering is carried out using this sintered body containing such pores, gas is irregularly formed from the pores during the sputtering and the uniformity of the film is reduced. Therefore, if the melting of the sintered particles is excessively advanced during atmospheric pressure sintering, the obtained sintered body is less suitable as the sputtering target. In the case of the sintered body formed by vacuum sintering, the above-mentioned problem of the pores does not arise. At a temperature lower than 1,300 ° C, the electroconductive active element is not property dissolved in lattices of zinc oxide and sintering is unsatisfactory, and therefore, a low-resistance sintered body cannot be obtained.

Accordingly, optimum sintering temperatures in the present invention are within the range of from about 1,400 ° C to about 1,500 ° C. Temperatures in the vicinity of the temperature at which the grain boundary of sintered particles begins to melt are especially preferred. If sintering is carried out under such conditions, a sintered body having properties specified in the present invention can be obtained.

In the present invention, the retention time at the above-mentioned sintering temperature is several hours to scores of hours, especially about 5 to about 20 hours.

Even in an air atmosphere, a sintered body having a required low resistance can be obtained if sintering is carried out at such a high temperature as described above, but if sintering is carried out in an inert atmosphere (e.g. argon, nitrogen or a noble gas) or in vacuo, that is, in an atmosphere having an oxygen concentration lower than that in air, the amount of occluded oxygen in the vicinity of particles to be sintered and in the grain boundary of sintered particles in the sintered body is reduced, and a sintered body having a lower resistance and a higher density may be obtained.

The specific resistance of the so-obtained zinc oxide sintered body is lower than 1Ω.cm, and in many cases, not higher than 0.1Ω.cm. The specific resistance of the sintered body can be reduced to about 0.001Ω.cm, and that of a thin film made therefrom can be reduced to about 0.0001 Ω.cm. Although the true density of zinc oxide is 5.8 g./cm$^3$, the density of the low-resistance sintered body obtained by high-temperature sintering according to the present invention is at least 5 g/cm$^3$. and can be up to about 95% of the true density.

The low-resistance zinc oxide is sintered body of the present invention may have excellent properties as the sputtering target for formation of a transparent electroconductive film. Therefore, the sintered body of the present invention can be applied not only to the high-frequency sputtering method but also to the industrial direct current sputtering method. If the sintered body of the present invention is used, in each of these sputtering methods, the discharge stage may be stable and a transparent electroconductive film having a very low resistance and an excellent transparency can be obtained. Moreover, since the oxide sintered body of the present invention can have a high density, the mechanical strength may also be high, and since the resistance can be low, the limit of the applicable electric power and film-forming speed may be increased.

The present invention will now be described in detail with reference to the following examples.

Example 1

Zinc oxide was mixed with an oxide of an element shown in Table 1 at a weight ratio of 98/2, and the mixture was pulverized to an average particle diameter of 0.5 µm and molded into a disc 100 mm in diameter and 10 mm in thickness by using a mold press. The molded body was sintered in air for 5 hours in an electric furnace. The specific resistance and sinter densities of sintered bodies obtained at temperatures shown in Table 1 are shown in Table 1. For comparison, the specific resistances and sintered densities of sintered bodies obtained at sintering temperatures of 1,100 and 1,200 °C are shown in Table 1.

The specific resistance of the sintered body was lowest where sintering was carried out at a temperature of at least 1,300 °C and the sintered density was at least 5 g/cm$^3$ if the sintering temperature was at least 1,300 °C. If the sintering temperature exceeded 1,400 °C, the hue of the sintered body was changed from yellow to a deep green color and melting of the grain boundary of sintered particles was observed.

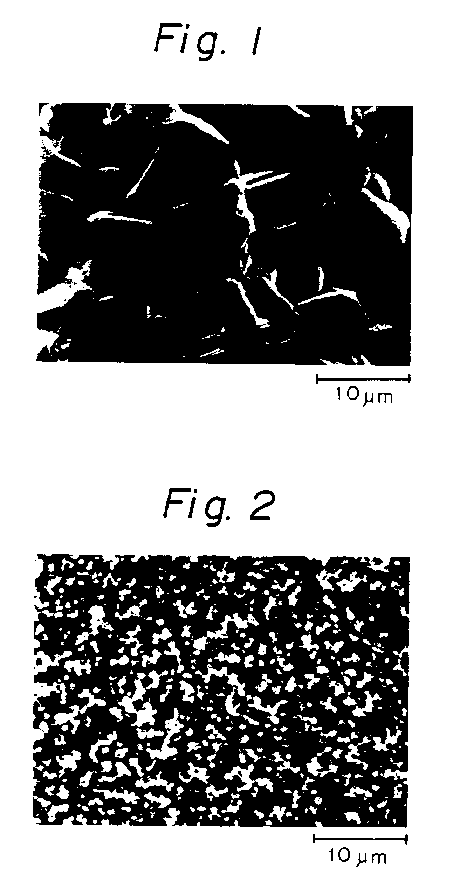

The scanning electron microscope (2,000 magnification) showing the state of sintered particles of the aluminium-added zinc oxide sintered body (sintering temperature = 1,400 °C) is shown in Figure 1. A similar photograph showing a sintered body obtained by sintering at 1,100 °C is shown in Figure 2. Note, if a zinc oxide sintered body absorbs oxygen, dispersion of the specific resistance occurs. Accordingly, the measurement of the specific resistance was conducted in an Ar gas atmosphere.

Furthermore, in the present example and subsequent examples, the specific resistance was measured according to the four-probe method, and the sinter density was measured by a usual method.

Example 2

Zinc oxide was mixed with an oxide of an element shown in Table 1 at a molar ratio of 98/2 and the mixture was pulverized and molded in the same manner as described in Example 1. In the same apparatus as used in Example 1, the pulverized oxide mixture was sintered in an argon atmosphere at 1,300 °C for 5 hours. The specific resistance and sintered density of the obtained sintered body are shown in Table 1. Where sintering was carried out in an inert atmosphere, the oxygen concentration in the grain boundary of the sintered body was reduced and the sintering property was improved, and a sintered body having a low resistance and a high density was obtained.

Table 1

| Dopant | | Sintering temperature(C°) | | | | | | |
|---|---|---|---|---|---|---|---|---|
| | | Sintering in air | | | | | | Sintering in argon |
| | | 1100 | 1200 | 1300 | 1400 | 1500 | 1600 | 1300 |
| Al | S.R.*1 | $1x10^4$ | $1x10^2$ | 80 | 0.1 | 0.02 | 0.02 | 0.005 |
| | S.D.*2 | 3.5 | 3.6 | 4.2 | 5.2 | 5.3 | 5.3 | 5.6 |
| In | S.R. | $1x10^4$ | $1x10^4$ | 10 | 0.02 | 0.02 | 0.02 | 0.005 |
| | S.D. | 3.5 | 3.7 | 4.2 | 5.1 | 5.3 | 5.3 | 5.6 |
| Sn | S.R. | $1x10^4$ | $1x10^3$ | 15 | 10 | 0.01 | 0.01 | 0.005 |
| | S.D. | 3.5 | 4.1 | 4.9 | 4.9 | 5.1 | 5.2 | 5.6 |
| Si | S.R. | $1x10^4$ | $1x10^4$ | 13 | 0.02 | 0.02 | 0.02 | 0.01 |
| | S.D. | 3.5 | 3.7 | 4.6 | 5.1 | 5.2 | 5.2 | 5.6 |
| Ti | S.R. | $1x10^4$ | $1x10^4$ | 60 | 0.03 | 0.02 | 0.02 | 0.01 |
| | S.D. | 3.5 | 3.7 | 5 | 5.1 | 5.2 | 5.2 | 5.5 |
| Ge | S.R. | $1x10^2$ | $1x10^2$ | 1 | 0.1 | 0.05 | 0.03 | 0.02 |
| | S.D. | 3.5 | 3.8 | 4.3 | 5.3 | 5.3 | 5.3 | 5.5 |
| Zr | S.R. | $1x10^5$ | $1x10^3$ | 20 | 10 | 0.05 | 0.03 | 0.5 |
| | S.D. | 3.4 | 3.6 | 4.5 | 4.7 | 5.2 | 5.3 | 5.3 |

*1 S.R.: specific resistance (Ω•cm)

*2 S.D.: sintered density ($g/cm^3$)

Example 3

Transparent electroconductive films were prepared under sputtering conditions described below by using the sintered bodies obtained in Examples 1 and 2 as sputtering targets. The characteristics of the obtained transparent electroconductive films are shown in Table 2.

| | |
|---|---|
| Sputtering device: | parallel electrode DC magnetron sputter |
| Target size: | 3 inches |
| Applied electric power: | 5 $W/cm^2$ |
| Sputtering gas: | Ar |
| Sputtering pressure: | 0.5 Pa |
| Substrate: | quartz glass |
| Substrate temperature: | 200 °C |

Table 2

| | Dopant | Sintered density of target ($g/cm^3$) | Specific resistance of target (Ω•cm) | Specific resistance of film (mΩ•cm) | Light transmission of film (% at 550 nm) |
|---|---|---|---|---|---|
| Sintered bodies obtained in example 1 | Al | 5.2 | 0.1 | 0.4 | 85 |
| | In | 5.1 | 0.02 | 0.4 | 85 |
| | Sn | 5.1 | 0.01 | 0.5 | 85 |
| | Si | 5.1 | 0.02 | 0.4 | 85 |
| | Ti | 5.1 | 0.03 | 0.4 | 85 |
| | Ge | 5.3 | 0.1 | 0.4 | 85 |
| | Zr | 5.2 | 0.05 | 0.5 | 85 |
| Sintered bodies obtained Example 2 | Al | 5.6 | 0.005 | 0.3 | 85 |
| | In | 5.6 | 0.005 | 0.3 | 85 |
| | Sn | 5.6 | 0.005 | 0.3 | 85 |
| | Si | 5.6 | 0.01 | 0.3 | 85 |
| | Ti | 5.5 | 0.01 | 0.3 | 85 |
| | Ge | 5.5 | 0.02 | 0.3 | 85 |
| | Zr | 5.3 | 0.5 | 0.5 | 85 |

Example 4

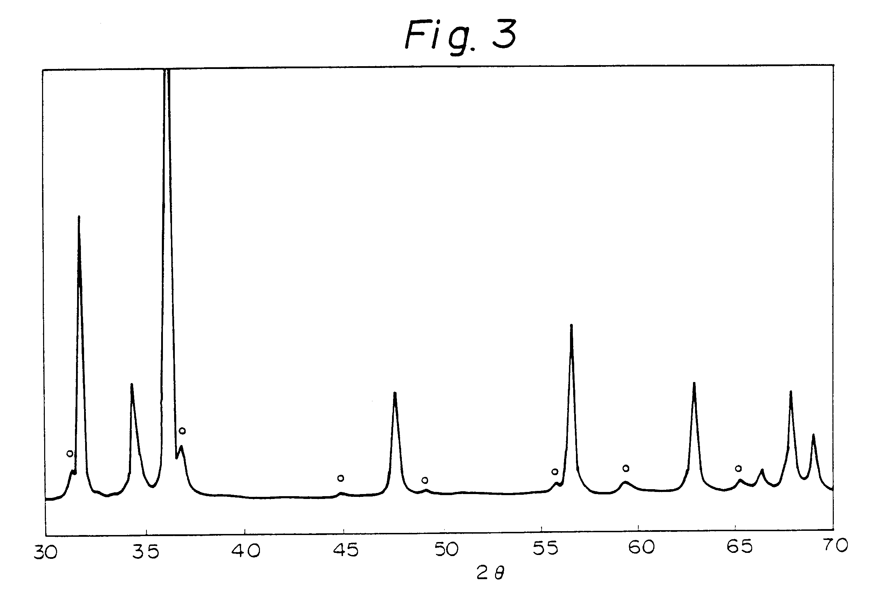

Zinc nitrate and aluminum nitrate were dissolved at a molar ratio of 1/2 in water, and the solution was neutralized with an alkali to coprecipitate zinc hydroxide and aluminum hydroxide at a molar ratio of 1/2. Since both elements are amphoteric, the netralization was precisely controlled so that the terminal point of netralization was substantially at a pH of 7. The obtained coprecipitated hydroxide was calcined at 800 °C to prepare a spinel structure oxide $ZnAl_2O_4$). When the obtained powder was analyzed by the X-ray diffractometry, it was found that the oxide was composed completely of a spinel structure. This spinel structure oxide was incorporated in an amount of 9% by weight into zinc oxide, and the thus-obtained mixture composed of 5% by weight of spinel $ZnAl_2O_4$ and 95% by weight of ZnO was molded in a mold and sintered at 1,400 °C in air for 5 hours to obtain a sintered body having a relatively low spinel structure content (df. Comparative Example 1). The X-ray diffraction chart of the obtained sintered body is shown the Figure 3, wherein the mark "o" indicates the peaks attributed to spinel $ZnA1_2O_4$ and the other peaks are attributed to ZnO.

Example 5

The spinel structure oxide prepared in Example 4 was incorporated at a weight ration of 3.6% into zinc oxide, and the mixture was molded in a mold and sintered at 1,400 °C for 5 hours. The sintered density of the obtained sintered body was 5.3 $g/cm^3$ and the specific resistance of the sintered body was 8 mΩ.cm as determined by the four-probe method. In a sintered body of zinc oxide, if oxygen is adsorbed, dispersion of the specific resistance occurs. Therefore, the measurement of the specific resistance was carried out in an inert gas atmosphere.

A transparent electroconductive film was made by the DC magnetron sputtering method using the obtained sintered body as the target.

The sputtering was carried out in a pure argon atmosphere on a quartz glass subtrate under a sintering pressure of 0.6 pA and an applied electric power of 4 $W/cm^2$. External heating was not conducted, and the substrate was maintained at room temperature.

The thickness of the obtained transparent electroconductive film was about 3,000 A, the specific resistance was 0.4 mΩ.cm and the light transmission at 550 nm was higher than 85%. Thus, it was confirmed that the obtained film had an excellent electroconductivity and transparency.

Example 6

Aluminum oxide was mixed at a weight ratio of 5% with zinc oxide (the aluminum content was the same as in Example 4), and the mixture was sintered under the same conditions as described in Example 4.

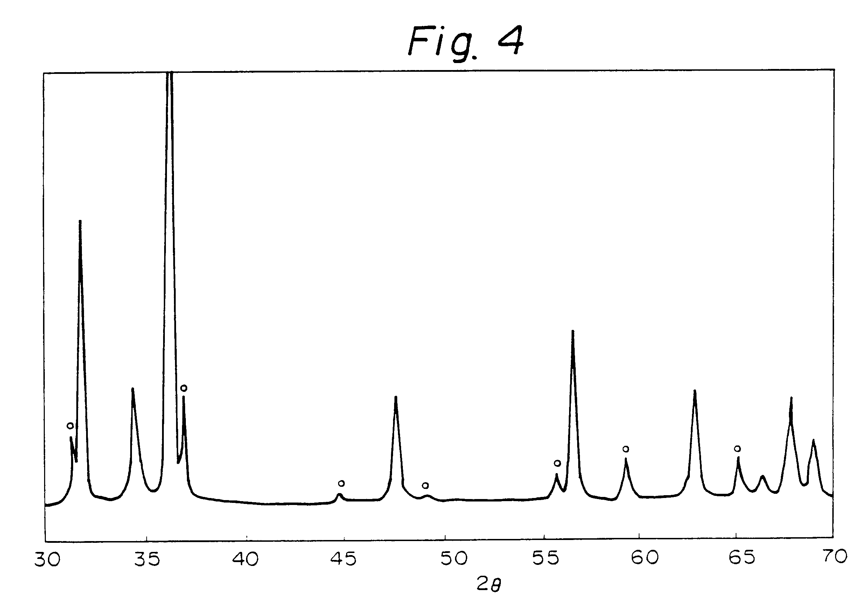

The X-ray diffraction chart of the obtained sintered body is shown in Figure 4, wherein the mark "o" indicates the peaks attributed to spinel $ZnA1_2O_4$ and the other peaks are attributed to ZnO. Although the obtained sintered body contained aluminum in the same amount as in the sintered body obtained in Example 4, the spinel intensity was much higher than in the sintered body obtained in Example 4.

Example 7

Aluminum oxide was mixed at a weight ratio of 2% with zinc oxide (the aluminum content was the same as in Example 5), and a sintered body was prepared under the same sintering conditions as described in Example 8, except that the sintering was carried out in an argon gas atmosphere.

The sintered density of the obtained sintered body was 5.3 $g/cm^3$, and the specific resistance of the sintered body was 15 mΩ.cm as determined by the four-probe method.

In the case of a sintered body of zinc oxide, if oxygen is absorbed, dispersion of the specific resistance is caused. Accordingly, the measurement of the specific resistance was conducted in an inert gas atmosphere.

A transparent electroconductive film was prepared by using the obtained sintered body as the target under the same conditions as described in Example 5. Although the transparency of the obtained film was comparable to that of the film obtained in Example 5, the specific resistance was 0.6 mΩ.cm, namely the film had a lower electroconductivity than the film obtained in Example 5.

## Claims

**1.** A zinc oxide sintered body containing from 0.1 to 20% by weight, based on the amount of zinc, of an oxide of an element capable of having a valency of at least three positive valences, the sintered body having a sintered density of at least 5 $g/cm^3$ and a specific resistance lower than 1 ohm.cm.

**2.** A zinc oxide sintered body doped with an element other than zinc or oxygen, which has a sintered density of at least 5 $g/cm^3$ and a specific resistance lower than 10 ohm.cm, wherein the total amount of the spinel structure contained in the sintered body does not exceed the amount of spinel (expressed by the formula $ZnX_2O_4$ in which X represents the element added as a dopant) which would be formed if all the dopant element was present as a spinel structure.

**3.** A process for the preparation of a zinc oxide sintered body having a sintered density of at least 5 $g/cm^3$ and a specific resistance lower than 1 ohm.cm, which comprises sintering zinc oxide containing from 0.1 to 20% by weight, based on the amount of zinc, of an oxide of an element capable of having a valency of at least three positive valences at a temperature of at least 1400 °C in air, or at a temperature of at least 1300 °C in an inert atmosphere or in vacuo.

**4.** A process as claimed in Claim 3, wherein the zinc oxide containing the element is in the form of a highly dispersible powder having a primary particle diameter not larger than 1 μm and a specific surface area of at least 2$m^2$/g.

**5.** A process for the preparation of a low-resistance zinc oxide sintered body as claimed in Claim 3 or Claim 4 wherein a spinel structure oxide represented by the formula $ZnX_2O_4$, wherein X represents the said element, is mixed with zinc oxide, and the mixture is sintered.

6. A process as claimed in Claim 5, wherein the spinel structure oxide of the formula $ZnX_2O_4$ is prepared by a heat treatment at a temperature of 500 to 1,000 °C.

7. A process as claimed in any of Claims 3 to 6, wherein the sintering is carried out at a temperature of lower than 1700 °C.

8. A sputtering target comprising a sintered body as claimed in Claim 1 or Claim 2, and/or prepared by a process as claimed in any of Claims 3 to 7.

**Patentansprüche**

1. Zinkoxid-Sinterkörper, enthaltend 0,1 bis 20 Gew.-%, bezogen auf die Zinkmenge, eines Oxides eines mindestens positiv-dreiwertigen Elements, mit einer Sinterdichte von mindestens 5 g/cm$^3$ und einem spezifischen Widerstand von kleiner als 1 Ohm•cm.

2. Zinkoxid-Sinterkörper, dotiert mit einem anderen Element als Zink oder Sauerstoff, mit einer Sinterdichte von mindestens 5 g/cm$^3$ und einem spezifischen Widerstand von kleiner als 10 Ohm•cm, wobei die Gesamtmenge der Spinellstruktur im Sinterkörper nicht die Spinellmenge (ausgedrückt durch die Formel $ZnX_2O_4$, in der X das als Dotiermittel zugesetzte Element darstellt), welche entstünde, wenn das Dotiermittel vollständig als Spinellstruktur vorläge, überschreitet.

3. Verfahren zur Herstellung eines Zinkoxid-Sinterkörpers mit einer Sinterdichte von mindestens 5 g/cm$^3$ und einem spezifischen Widerstand von kleiner als 1 Ohm•cm, welches das Sintern des Zinkoxids, enthaltend 0,1 bis 20 Gew.-%, bezogen auf die Zinkmenge, eines Oxides eines mindestens positiv-dreiwertigen Elements, bei einer Temperatur von mindestens 1400 °C in Luft, oder einer Temperatur von mindestens 1300 °C in einer inerten Atmosphäre oder im Vakuum umfaßt.

4. Verfahren nach Anspruch 3, wobei das Zinkoxid, welches das Element enthält, in Form eines hochdispersiblen Pulvers mit einem primären Teilchendurchmesser von nicht größer als 1 µm und einer spezifischen Oberfläche von mindestens 2 m$^2$/g vorliegt.

5. Verfahren zur Herstellung eines Zinkoxid-Sinterkörpers mit geringem Widerstand gemäß Anspruch 3 oder Anspruch 4, wobei ein Oxid mit Spinellstruktur, dargestellt durch die Formel $ZnX_2O_4$, wobei X das Element darstellt, mit dem Zinkoxid gemischt und die Mischung gesintert wird.

6. Verfahren nach Anspruch 5, wobei das Oxid mit Spinellstruktur der Formel $ZnX_2O_4$ durch eine Hitzebehandlung bei einer Temperatur von 500 bis 1000 °C hergestellt wird.

7. Verfahren nach einem der Ansprüche 3 bis 6, wobei das Sintern bei einer Temperatur von weniger als 1700 °C durchgeführt wird.

8. Target beim Sputtern, umfassend einen Sinterkörper gemäß Anspruch 1 oder Anspruch 2 und/oder hergestellt nach einem Verfahren gemäß einem der Ansprüche 3 bis 7.

**Revendications**

1. Corps fritté en oxyde de zinc contenant de 0,1 à 20 % en poids, par rapport à la quantité de zinc, d'un oxyde d'un élément dont la valence peut être d'au moins trois valences positives, ledit corps fritté possédant une densité d'au moins 5 g/cm$^3$ et une résistance spécifique inférieure à 1 Ω.cm.

2. Corps fritté à base d'oxyde de zinc, dopé avec un élément autre que du zinc ou de l'oxygéne, qui présente une densité a l'état fritté d'au moins 5 g/cm$^3$ et une résistance spécifique inférieure à 10 Ω.cm, dans lequel la proportion totale de structure spinelle présente dans le corps fritté ne dépasse pas la proportion de spinelle (exprimé par la formule $ZnX_2O_4$ dans laquelle X représente l'élément ajouté comme dopant) qui serait formé si tout l'élément dopant était présent à l'état de structure spinelle.

**3.** Procédé pour la préparation d'un corps fritté à base d'oxyde de zinc, présentant une densité à l'état fritté d'au moins 5 g/cm$^3$ et une résistance spécifique inférieure à 1 Ω.cm, qui comprend le frittage d'oxyde de zinc contenant de 0,1 à 20 % en poids, par rapport à la quantité de zinc, d'un oxyde d'un élément dont la valence peut valoir au moins trois valences positives, à une température d'au moins 1400 °C dans l'air ou à une température d'au moins 1300 °C dans une atmosphère inerte ou sous vide.

**4.** Procédé selon la revendication 3, dans lequel l'oxyde de zinc contenant l'élément se présente sous forme d'une poudre très dispersable dont le diamètre de particules primaires n'est pas supérieur a 1 µm et dont l'aire spécifique vaut au moins 2 m$^2$/g.

**5.** Procédé pour la préparation d'un corps fritté à base d'oxyde de zinc de faible résistance, tel que revendiqué dans la revendication 3 ou la revendication 4, dans lequel on mélange avec de l'oxyde de zinc un oxyde de structure spinelle représentée par la formule $ZnX_2O_4$, dans laquelle X représente ledit élément, et on fritte le mélange obtenu.

**6.** Procédé selon la revendication 5, dans lequel L'oxyde de structure spinelle de la formule $ZnX_2O_4$ est préparé par un traitement thermique à une température de 500 à 1000 °C.

**7.** Procédé selon une quelconque des revendications 3 à 6, dans lequel le frittage est réalisé à une température inférieure à 1700 °C.

**8.** Cible de pulvérisation comprenant un corps fritté tel que revendiqué dans la revendication 1 ou 2 et/ou préparé par un procédé selon l'une quelconque des revendications 3 à 7.

Fig. 1

10 μm

Fig. 2

10 μm

Fig. 3
30
35
40
45
50
55
60
65
70
2θ

Fig. 4
2θ
30
35
40
45
50
55
60
65
70